# EUROPÄISCHE PATENTSCHRIFT

(11) **EP 2 984 390 B1**
(45) Veröffentlichungstag und Bekanntmachung des Hinweises auf die Patenterteilung: **09.05.2018**
(21) Anmeldenummer: 14711505.9
(22) Anmeldetag: 19.03.2014
(51) Int. Cl.: F21K 9/00, F21V 5/04, F21V 17/02, F21V 5/00, F21V 7/00, F21V 17/00, F21V 17/10, F21V 23/00, F21Y 101/00, F21Y 115/10, F21Y 105/10

(54) **ANORDNUNG ZUR LICHTABGABE MIT EINER LED, EINER PLATINE UND EINEM OPTISCHEN ELEMENT**
ASSEMBLY FOR EMITTING LIGHT HAVING AN LED, A CIRCUIT BOARD, AND AN OPTICAL ELEMENT
ENSEMBLE SERVANT À DIFFUSER DE LA LUMIÈRE COMPRENANT UNE LED, UNE PLATINE ET UN ÉLÉMENT OPTIQUE

(30) Priorität: 20.03.2013 DE 202013101190 U
(43) Veröffentlichungstag der Anmeldung: 17.02.2016
(73) Patentinhaber: Zumtobel Lighting GmbH, 6850 Dornbirn (AT)
(72) Erfinder: EBNER, Stephan, A-6850 Dornbirn (AT)
(74) Vertreter: Thun, Clemens
(86) Internationale Anmeldenummer: PCT/EP2014/055508
(87) Internationale Veröffentlichungsnummer: WO 2014/147126

(56) Entgegenhaltungen:
- DE-A1- 19 834 090
- DE-A1-102008 039 147
- US-A1- 2006 098 308
- US-A1- 2011 032 707
- US-A1- 2012 063 143

## Beschreibung

Die Erfindung betrifft eine Anordnung zur Lichtabgabe mit einer LED (LED: Licht emittierende Diode), einer Platine und einem optischen Element.

Aus dem Stand der Technik sind entsprechende Anordnungen bekannt, bei denen die LED und das optische Element auf der Platine angeordnet sind und dabei ein von der LED erzeugtes Licht durch das optische Element in bestimmter gewünschter Weise beeinflusst wird, beispielsweise um einen besonderen Winkelabstrahlbereich der Lichtabgabe der Anordnung zu erzielen. Dabei sind entsprechende optische Elemente in Form von Reflektoren einerseits und Linsenoptiken andererseits üblich. Letztere haben grundsätzlich gegenüber Reflektoren deutliche lichttechnische Vorteile. Allerdings werden Linsenoptiken typischerweise in Spritzgusstechnik gefertigt, so dass zu ihrer Herstellung - im Vergleich zu Reflektoren - prinzipiell ein deutlich größerer Aufwand erforderlich ist. Insbesondere sind entsprechende Herstellungswerkzeuge für solche optischen Elemente sehr kostenaufwändig.

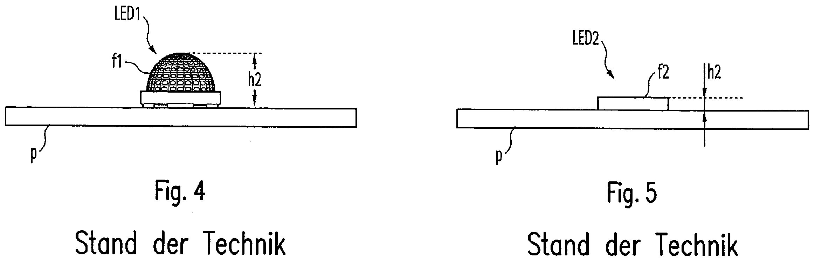

LEDs sind in sehr vielen unterschiedlichen Arten bzw. Bauformen bekannt. In Fig. 4 ist beispielhaft eine LED einer ersten Art *LED1* gezeigt, die auf einer Platine *p* angeordnet ist, in Fig. 5 entsprechend eine LED einer zweiten Art *LED2.* Die LED der ersten Art *LED1* weist eine Bauhöhe *h1* auf, die größer ist als die Bauhöhe *h2* der LED der zweiten Art *LED2.* Mit "Bauhöhe" sei hierbei die Erstreckung der betreffenden LED über die Oberfläche der Platine bezeichnet, wenn die LED wie vorgesehen auf der Platine angeordnet ist bzw. die maximale Höhe der Lichtabgabefläche der LED mit Bezug auf die Oberfläche der Platine p. Auch unterscheiden sich die beiden LEDs *LED1, LED2* in der Form der Lichtabgabefläche. Bei der LED der ersten Art *LED1* ist die Lichtabgabcfläche *f1* halbkugelförmig, bei der LED der zweiten Art *LED2* ist die Lichtabgabefläche *f2* plan.

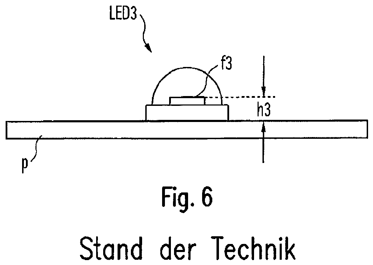

Bei der in Fig. 4 skizzierten LED1 befinden sich in der halbkugelförmigen Abdeckung Phosphorteilchen, die zur Wellenlängen-Konvertierung dienen, so dass die Oberfläche dieser Abdeckung die Lichtabgabefläche f1 der LED darstellt. In Fig. 6 ist ein Beispiel einer LED einer dritten Art LED3 skizziert, bei der sich die Lichtabgabefläche f3 in einer Höhe h3 befindet, da hier in der halbkugelförmigen Abdeckung keine Phosphorteilchen enthalten sind, so dass als Lichtabgabefläche die mit f3 bezeichnete, plane Oberfläche zu betrachten ist.

Dementsprechend unterscheiden sich LEDs im Allgemeinen in der Art und Weise ihrer Lichtabgabe, so dass es zur Herstellung einer entsprechenden Anordnung erforderlich ist, das optische Element in Abhängigkeit der betreffenden LED - bzw. die LED in Abhängigkeit des betreffenden optischen Elements - zu gestalten. Insbesondere ist dabei zu bedenken, dass ein entsprechendes optisches Element typischerweise zur Erzielung der gewünschten Lichtbeeinflussung in einem bestimmten Abstand von der Lichtabgabefläche der LED angeordnet werden muss. Daher erfordert die Herstellung entsprechender unterschiedlicher Anordnungen einen erheblichen Aufwand.

Aus der US 2012/0063143 A1 ist eine Anordnung mit einer Platine, einer darauf angeordneten LED und einem Linsenelement bekannt; dabei ist das Linsenelement mittels einer Auflage-Einheit an der Platine befestigt.

Weitere Anordnungen mit einer LED-Platine und einem Linsenelement, das über ein Halteelement an der LED-Platine befestigt ist, sind aus den Schriften US 2006/0098308 A1 und US 2011/0032707 A1 bekannt.

Aus der DE 10 2008 039 147 A1 ist ein optoelektronisches Modul mit einem Träger, einem darauf angeordneten Leuchtdiodenchip und einem optischen Element bekannt. Auf dem Träger ist außerdem ein Montageaufsatz befestigt, auf den das optische Element aufgebracht ist.

Aus der DE 198 34 090 A1 ist eine optoelektronische Sende- und Empfangseinheit mit einem Trägerelement bekannt, auf dem eine Sendeeinheit in Form einer LED angeordnet ist. Über der LED ist eine als Linse ausgebildete Strahlformungsoptik vorgesehen und über Letzterer eine elektronische Empfangseinheit mit einem strahlungsempfindlichen Schichtbereich.

Der Erfindung liegt die Aufgabe zugrunde, eine entsprechende verbesserte Anordnung anzugeben. Insbesondere soll sich die Anordnung für eine kostengünstige Herstellung eignen.

Diese Aufgabe wird gemäß der Erfindung mit dem in dem unabhängigen Anspruch genannten Gegenstand gelöst. Besondere Ausführungsraten der Erfindung sind in den abhängigen Ansprüchen angegeben.

Gemäß der Erfindung ist eine Anordnung zur Lichtabgabe vorgesehen, die eine Platine aufweist und eine LED zur Erzeugung eines Lichts, wobei die LED auf der Platine angeordnet ist. Weiterhin weist die Anordnung ein optisches Element auf, das derart angeordnet ist, das es das von der LED erzeugte Licht optisch beeinflusst. Außerdem weist die Anordnung ein Abstandshalter-Element auf, wobei das Abstandhalter-Element zwischen dem optischen Element und der Platine angeordnet ist.

Durch das Abstandshalter-Element lässt sich erzielen, dass für die Anordnung ein optisches Element gewählt werden kann, mit dem die gewünschte Lichtbeeinflussung nicht erzielt würde, wenn es unmittelbar auf der Platine angeordnet werden würde. Somit ist es ermöglicht, für die Herstellung der Anordnung auf die Fertigung eines speziellen optischen Elements zu verzichten. Die Anordnung kann daher besonders kostengünstig gefertigt werden.

Mit anderen Worten lässt sich erzielen, dass sich ein bestimmtes optisches Element für unterschiedliche LEDs eignet, insbesondere für LEDs, die sich in ihrer Bauhöhe und/oder in der Position des LED-Chips innerhalb des LED-Gehäuses unterscheiden. Zumindest innerhalb gewisser physikalischer Grenzen eignet sich ein entsprechendes optisches Element durch die erfindungsgemäße Anordnung auch für LEDs, die sich in der Größe und/oder Form der Lichtabgabefläche unterscheiden.

Weiterhin lässt sich durch das Abstandshalter-Element eine erleichterte Positionierung des optischen Elements relativ zu der Platine erzielen. Hierdurch lässt sich eine weitergehende Vereinfachung der Herstellung der Anordnung bewirken.

Erfindungsgemäß weist das Abstandshalter-Element ein Keramik-Material auf. Dabei ist das Abstandshalter-Element derart gestaltet, dass der Abstand zwischen der Platine und dem optischen Element kleiner ist als die Bauhöhe der LED. Vorteilhaft besteht das Abstandshalter-Element aus einem Keramik-Material. Hierdurch lässt sich praktisch ausschließen, dass das Abstandshalter-Element unerwünschte elektrische Wirkungen auf weitere Bauteile der Platine oder der Anordnung ausübt.

Vorzugsweise ist das Abstandshalter-Element durch ein elektrisches bzw. elektronisches Bauteil gebildet, beispielsweise durch einen elektrischen Widerstand oder eine Leitungsbrücke. Auf diese Weise lässt sich das Abstandshalter-Element vorteilhaft so gestalten, dass es nicht nur als Abstandshalter fungiert, sondern auch eine entsprechende weitere Funktion erfüllt. Hierdurch lässt sich ein entsprechendes gesondertes elektrisches bzw. elektronisches Bauteil einsparen.

Eine besonders einfache Montage des Abstandshalter-Elements auf der Platine ist ermöglicht, wenn das elektrische bzw. elektronische Bauteil durch ein oberflächenmontiertes Bauelement bzw. ein SMD (SMD: surface mounted device) gebildet ist bzw. durch Oberflächenmontage an der Platine angeordnet ist. In diesem Fall lässt sich die Platine mit dem Abstandshalter-Element auch besonders geeignet bestücken, insbesondere automatisch bestücken. Beispielsweise vorteilhaft ist das Abstandshalter-Element durch einen Null-Ohm-Widerstand gebildet.

Eine besonders einfache Herstellung der Anordnung ist weiterhin ermöglicht, wenn das Abstandshalter-Element unmittelbar auf der Platine angeordnet ist.

Vorzugsweise ist dabei durch die Platine, die LED und das Abstandshalter-Element ein LED-Modul mit einer integrierten Höhenpositionierung für das optische Element gebildet ist.

Wenn das optische Element unmittelbar mit dem Abstandshalter-Element verbunden angeordnet ist, lässt sich ein weiteres Bauteil vermeiden und die Anordnung auf einfache Weise besonders stabil ausführen. Vorzugsweise ist das optische Element an dem Abstandshalter-Element mechanisch gehaltert angeordnet. Hierdurch lässt sich ein gesondertes Halteelement zur Halterung des optischen Elements an der Platine einsparen.

Das optische Element ist vorzugsweise ein Linsenelement. Es kann beispielsweise vorteilhaft durch eine Linse, ein Linsenarray, eine Linsenplatte, eine Kunststoffoptik-Platte etc. gebildet sein. Die Anordnung ist besonders geeignet, wenn das optische Element in Spritzgusstechnik oder durch Extrusion gefertigt ist.

Eine weitere vorteilhafte Gestaltung ist gegeben, wenn die Anordnung weiterhin wenigstens eine weitere LED zur Erzeugung eines weiteren Lichts aufweist, wobei das optische Element derart gestaltet und angeordnet ist, dass es auch das von der wenigstens einen weiteren LED erzeugte weitere Licht optisch beeinflusst. Auf diese Weise muss nicht für jede LED der Anordnung ein separates optisches Element vorgesehen werden.

Weiterhin vorteilhaft ist das Abstandshalter-Element als Positionierhilfe-Element zur Positionierung des optischen Elements relativ zu der LED bzw. zu der Platine ausgestaltet. Insbesondere kann das Abstandshalter-Element als Positionierhilfe-Element zur Sicherung einer Längsposition des optischen Elements und/oder zur Sicherung einer bestimmten Drehposition des optischen Elements relativ zu der LED bzw. zu der Platine ausgebildet sein. Auf diese Weise lässt sich das optische Element besonders einfach relativ zu der Platine bzw. zu der LED bzw. den LEDs platzieren. Somit ist auch hierdurch die Herstellung der Anordnung erleichtert.

Die Erfindung wird im Folgenden anhand eines Ausführungsbeispiels und mit Bezug auf die Zeichnungen näher erläutert. Es zeigen:
- Fig. 1: eine Querschnittskizze zu einer erfindungsgemäßen Anordnung,
- Fig. 2: eine Querschnittskizze zu zwei Anordnungen mit zwei unterschiedlichen LEDs,
- Fig. 3: eine Skizze zur Veranschaulichung der Lichtbeeinflussung im Fall der beiden in Fig. 2 skizzierten Anordnungen und
- Figuren 4 bis 6: drei Skizzen zu unterschiedlichen LEDs gemäß dem Stand der Technik.

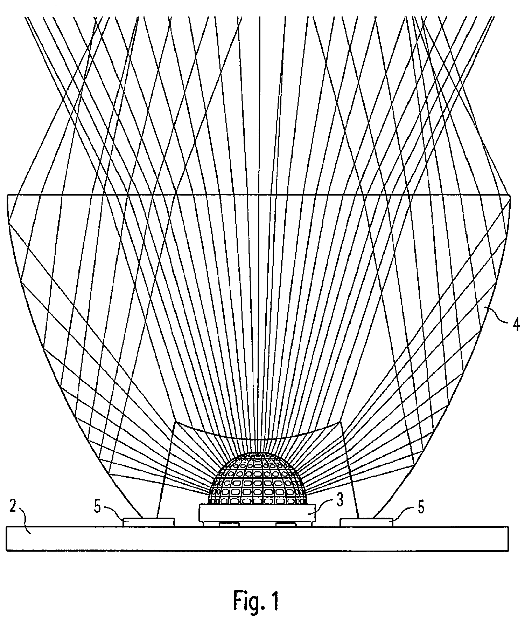

Fig. 1 zeigt eine schematische Querschnitt-Darstellung einer erfindungsgemäßen Anordnung zur Lichtabgabe. Die Anordnung weist eine Platine 2 auf, sowie eine LED 3 zur Erzeugung eines Lichts. Die LED 3 ist auf der Platine 2, insbesondere unmittelbar auf der Platine 2 angeordnet. Vorzugsweise ist die LED 3 als oberflächenmontiertes Bauelement auf der Platine 2 angeordnet bzw. als SMD.

Weiterhin weist die Anordnung ein optisches Element 4 auf, das derart angeordnet ist, dass es das von der LED 3 erzeugte Licht optisch beeinflusst, beispielsweise durch Bündelung. Bei dem optischen Element 4 handelt es sich beispielsweise um ein Linsenelement, beispielsweise in Form eines Linsenarrays, einer Linsenplatte oder einer Kunststoffoptik-Platte.

Vorzugsweise ist die Anordnung derart gestaltet, dass das von der LED 3 erzeugte Licht die Anordnung lediglich verlassen kann, wenn es zuvor durch das optische Element 4 beeinflusst worden ist, insbesondere das optische Element 4 durchsetzt hat. Dementsprechend ist das optische Element 4 vorzugsweise so gestaltet, dass es die LED 3 bzw. deren Lichtabgabefläche umgreifend angeordnet ist.

Das optische Element 4 kann beispielsweise in Spritzgusstechnik oder durch Extrusion gefertigt sein. Zur Herstellung des optischen Elements 4 durch Spritzgusstechnik ist ein entsprechendes Herstellungswerkzeug erforderlich, so dass die Herstellung des optischen Elements 4 einen nennenswerten Anteil an dem gesamten Aufwand einnimmt, der zur Herstellung der Anordnung insgesamt erforderlich ist.

Weiterhin weist die Anordnung ein Abstandshalter-Element 5 auf, das zwischen dem optischen Element 4 und der Platine 2 angeordnet ist. Das Abstandshalter-Element 5 dient zur Erzielung eines bestimmten Abstands zwischen dem optischen Element 4 und der Platine 2. Insbesondere kann vorgesehen sein, dass das Abstandshalter-Element 5 unmittelbar an der Platine 2 angeordnet ist und/oder dass das optische Element 4 unmittelbar mit dem Abstandshalter-Element 5 verbunden angeordnet ist, insbesondere an Letzterem mechanisch gehaltert ist. Auf diese Weise sind keine weiteren Bauteile zur Erzielung des gewünschten Abstands bzw. zur Halterung des optischen Elements 4 erforderlich.

Durch das Abstandshalter-Element 5 lässt sich erzielen, dass das optische Element 4 mit einem derartigen Abstand von der Platine 2 und damit von der LED 3 angeordnet ist, dass es eine bestimmte gewünschte optische Beeinflussung des von der LED 3 erzeugten Lichts hervorruft. Im gezeigten Beispiel wird das von der LED 3 erzeugte und abgegebene Licht durch das optische Element 4 gebündelt. Die optische Wirkung bzw. Bündelwirkung ist dabei abhängig von dem Abstand zwischen der Platine 2 und dem optischen Element 4, so dass durch Veränderung dieses Abstands Einfluss auf die optische Wirkung genommen werden kann. Durch das Abstandshalter-Element 5 lässt sich ein bestimmter Abstand und somit eine bestimmte optische Wirkung erzielen.

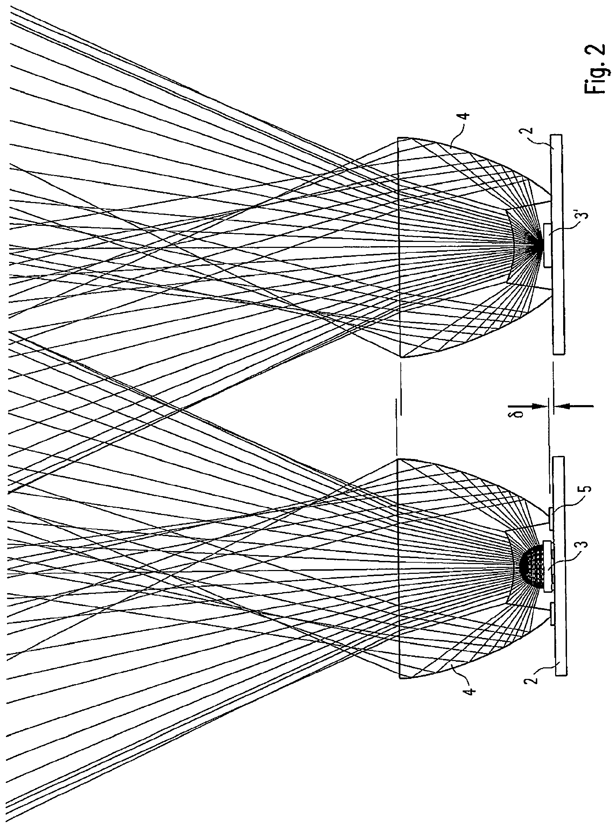

Anhand der Fig. 2 sei der Vorteil des Abstandshalter-Elements 5 weitergehend beispielhaft illustriert. Die Bezugszeichen sind analog gebraucht. In Fig. 2 ist eine verkleinerte Wiedergabe der in Fig. 1 skizzierten Anordnung, im Folgenden auch als "erste" Anordnung bezeichnet, gezeigt. Neben der ersten Anordnung ist eine zweite Anordnung skizziert, die sich von der ersten Anordnung unter anderem durch die Art der verwendeten LED unterscheidet. Während die LED 3 der ersten Anordnung die in Fig. 4 gezeigte LED der "ersten" Art ist, weist die zweite Anordnung eine LED - hier mit 3' bezeichnet - auf, wie sie in Fig. 5 gezeigt ist, also eine LED der "zweiten" Art.

Die beiden LEDs 3, 3' unterscheiden sich, wie eingangs erläutert, insbesondere in ihren Bauhöhen.
Beide Anordnungen weisen dasselbe optische Element 4 auf.

Bei der zweiten Anordnung sind die Verhältnisse nun derart, dass das optische Element 4 unmittelbar an der Platine 2 angeordnet ist und auf diese Weise eine gewünschte Lichtabgabe der Anordnung erzielt wird. Bei der ersten Anordnung hingegen ist das optische Element 4 - wie oben ausgeführt - über das Abstandshalter-Element 5 mit der Platine 2 verbunden, so dass im Unterschied zu der zweiten Anordnung hier ein kleiner Abstand *δ* zwischen der Platine 2 und dem optischen Element 4 gegeben bzw. festgelegt ist. Durch diesen Abstand *δ* lässt sich erzielen, dass das optische Element 4 der ersten Anordnung eine Abstrahlung der ersten Anordnung bewirkt, die praktisch identisch ist zu der Abstrahlung der zweiten Anordnung. Dies ist in Fig. 2 durch exemplarisch gezeichnete Lichtstrahlen der beiden Anordnungen angedeutet.
Ohne die Verwendung des Abstandshalter-Elements 5 würde sich die Abstrahlung der ersten Anordnung von der Abstrahlung der zweiten Anordnung in deutlich wahrnehmbarer Weise unterscheiden. Das optische Element 4 würde bei der ersten Anordnung ohne Verwendung des Abstandshalter-Elements 5 das Licht nicht in gewünschter Weise beeinflussen können.
Bisher war es üblich, für einen speziellen LED-Typ eine spezielle Linsenoptik zu entwickeln. Durch die erfindungsgemäße Anordnung lässt sich nunmehr erzielen, dass sich ein optisches Element zur Erzielung eines bestimmten Lichtabgabeverhaltens bei entsprechenden Anordnungen eignet, die sich hinsichtlich des verwendeten LED-Typs unterscheiden. Somit lässt sich das Einsatzspektrum von entsprechenden, relativ teuren optischen Elementen vergrößern.

Das Abstandshalter-Element 5 ist derart gestaltet, dass der Abstand *δ* zwischen der Platine 2 und dem optischen Element 4 kleiner ist als die Bauhöhe der LED 3. Im gezeigten Beispiel ist der Abstand *δ* kleiner als die Hälfte der Bauhöhe der LED 3. Bei der LED 3 handelt es sich, wie erwähnt, vorzugsweise um ein SMD. Die Bauhöhe der LED 3 ist dementsprechend klein, vorzugsweise kleiner als 5 mm, insbesondere kleiner als 4 mm, besonders bevorzugt kleiner als 2 mm.

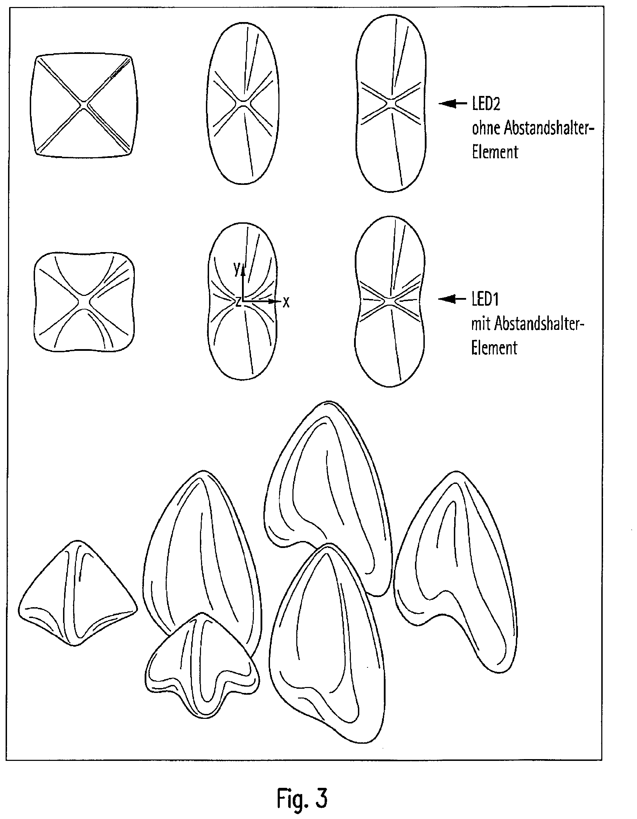

In Fig. 3 ist der beschriebene Effekt weitergehend illustriert. In der oberen Zeile, links, ist eine etwa pyramidenartige Lichtabstrahl-Figur gezeigt, die das Abstrahlverhalten der zweiten Anordnung - aus dem Blickwinkel der LED - symbolisch darstellt. Darunter in der zweiten Zeile ist eine entsprechende Lichtabstrahl-Figur für die erste Anordnung - also unter Verwendung des Abstandshalter-Elements 5 - skizziert. Im unteren Bereich der Zeichnung sind diese beiden Lichtabstrahl-Figuren perspektivisch wiedergegeben. Man erkennt, dass sich die beiden Lichtabstrahl-Figuren, also die Abstrahlverhalten der beiden Anordnungen praktisch nicht unterscheiden.

Eine entsprechende Wirkung lässt sich auch für anders wirkende optische Elemente erzielen. In Fig. 3 ist dies anhand entsprechender Lichtabstrahl-Figuren im Fall von zwei weiteren (als solchen nicht gezeigten) optischen Elementen exemplarisch skizziert.

Die Anordnung kann weiterhin wenigstens ein weiteres Abstandshalter-Element aufweisen, das analog zu dem zuerst genannten Abstandshalter-Element 5 gestaltet ist. Insbesondere kann die Anordnung derart gestaltet sein, dass sie anstelle des zuerst genannten Abstandshalter-Elements 5 dieses zuerst genannte Abstandshalter-Element 5 und das wenigstens eine weitere Abstandshalter-Element aufweist, wobei die beschriebene Wirkung der betreffenden Teile in beiden Fällen identisch ist. Im Folgenden wird daher lediglich der Ausdruck "das" Abstandshalter-Element 5 verwendet, wobei dieser Ausdruck auch entsprechende mehrere Abstandshalter-Elemente umfassen soll. Unter anderer Betrachtungsweise bzw. mit anderen Worten kann das (zuerst genannte) Abstandshalter-Element 5 mehrteilig gestaltet sein.

Vorzugsweise ist das Abstandshalter-Element 5 in einem kleinen Umgebungsbereich der LED 3 auf der Platine 2 angeordnet, so dass eine besonders stabile Abstützung des optischen Elements 4 ermöglicht ist. Der Durchmesser des Umgebungsbereichs ist dabei vorzugsweise kleiner als das Fünffache des Durchmessers der LED 3, vorzugsweise kleiner als das Dreifache des Durchmessers der LED 3.

Das Abstandshalter-Element 5 kann ein Keramik-Material aufweisen. Es kann insbesondere aus einem Keramik-Material bestehen. Auf diese Weise lässt sich eine unerwünschte elektrische Wechselwirkung mit weiteren Bauteilen der Anordnung, insbesondere elektronischen Bauteilen, mit der die Platine 2 bestückt ist, praktisch vermeiden.

Das Abstandshalter-Element 5 kann jedoch auch durch ein elektrisches bzw. elektronisches Bauteil gebildet sein, beispielsweise durch einen elektrischen Widerstand oder durch eine Leitungsbrücke. Beispielsweise kann das Abstandshalter-Element durch einen Null-Ohm-Widerstand gebildet sein.

Hierdurch lässt sich eine vorteilhafte Doppelfunktion des Abstandshalter-Elements 5 erzielen, durch die sich ein entsprechendes gesondertes Bauteil der Anordnung einsparen lässt. Dabei kann es sich besonders vorteilhaft um ein oberflächenmontiertes Bauelement handeln bzw. ein SMD, so dass eine besonders einfache, insbesondere automatisierte Bestückung der Platine mit dem Abstandshalter-Element ermöglicht ist. Auf diese Weise lässt sich das Abstandshalter-Element 5 herstellungstechnisch vorteilhaft in einem Arbeitsgang auf der Platine 2 anordnen, in dem die Platine 2 - wie an sich üblich - mit elektrischen bzw. elektronischen Bauteilen bestückt wird. Das Abstandshalter-Element 5 ist also vorteilhaft durch eine Oberflächenmontage an der Platine 2 angeordnet.

Die Nutzung der Oberflächenmontage ist insbesondere auch bei der Fertigung entsprechender unterschiedlicher Anordnungen von Vorteil, die sich in der Art bzw. Bauform der jeweils verwendeten LED, jedoch nicht in der Bauform des optischen Elements unterscheiden. In diesem Fall lassen sich die jeweiligen Platinen mit den LEDs, also die LED-Module, im Rahmen der Bestückung jeweils mit einem, entsprechend auf die Bauform der verwendeten LED abgestimmten, geeigneten Abstandshalter-Element versehen bzw. bestücken, so dass im weiteren Fertigungsprozess die Art bzw. Bauform der jeweiligen LED und deren Zusammenwirken mit dem betreffenden optischen Element nicht mehr gesondert berücksichtigt werden muss. Durch das Abstandshalter-Element 5 lässt sich sozusagen eine, in das LED-Modul "integrierte Höhenpositionierung" für das optische Element 4 bewirken.

Bei der Fertigung entsprechender unterschiedlicher Anordnungen lässt sich dementsprechend das optische Element vorzugsweise so gestalten, dass es sich - ohne Verwendung eines Abstandshalter-Elements - für diejenige der verwendeten LEDs wie gewünscht eignet, die die kleinste Bauhöhe aufweist. Für andersartige LEDs kann dann jeweils ein Abstandshalter-Element vorgesehen sein, das eine entsprechende, auf die jeweilige LED-Art abgestimmte Höhe aufweist bzw. einen entsprechenden Abstand *δ* gewährleistet.

In dem in Fig. 1 skizzierten Beispiel stellt die LED 3 die einzige LED der Anordnung dar. Im Allgemeinen kann die Anordnung jedoch auch mehrere LEDs aufweisen, also zusätzlich wenigstens eine weitere LED zur Erzeugung eines weiteren Lichts. Die wenigstens eine weitere LED ist dabei vorzugsweise analog zu der zuerst genannten LED 3 gestaltet.

Vorteilhaft ist in diesem Fall das optische Element 4 derart gestaltet und angeordnet, dass es auch das von der wenigstens einen weiteren LED erzeugte weitere Licht optisch beeinflusst. In einem solchen Fall ist das optische Element typischerweise entsprechend größer gestaltet und die oben erwähnte Ausbildung des Abstandhalter-Elements in mehrteiliger Form kann hierbei besonders vorteilhaft sein. Das optische Element muss dann zur Gewährleistung des Abstands *δ* lediglich an zwei oder mehr Stellen mit entsprechenden Abstandshalter-Element-Teilen unterstützt sein.

Eine weitere vorteilhafte Ausgestaltung des Abstandshalter-Elements 5 ergibt sich, wenn Letzteres auch als Positionierhilfe-Element zur Positionierung des optischen Elements 4 relativ zu der LED 3 bzw. der Platine 2 ausgestaltet ist. Insbesondere kann es hierbei zur Sicherung einer Längsposition des optischen Elements 4 und/oder zur Sicherung einer bestimmten Drehposition des optischen Elements 4 relativ zu der LED 3 bzw. zu der Platine 2 ausgebildet sein. Durch die Gestaltung als Positionierhilfe-Element wird eine definierte Positionierung für das optische Element 4 ermöglicht, wodurch sich die durch das optische Element 4 erzielte Lichtbeeinflussung besonders zuverlässig und einfach bewirken lässt.

Die erfindungsgemäße Anordnung ermöglicht eine besonders kostengünstige und platzsparende Ausgestaltung. Sie ist besonders fertigungsfreundlich. Das Streulichtverhalten in der Abstrahlcharakteristik der Anordnung lässt sich passend zur betreffenden LED verbessern.

## Patentansprüche

1. Anordnung zur Lichtabgabe, aufweisend
- eine Platine (2),
- eine LED (3) zur Erzeugung eines Lichts,
wobei die LED (3) auf der Platine (2) angeordnet ist,
- ein optisches Element (4), das derart angeordnet ist, dass es das von der LED (3) erzeugte Licht optisch beeinflusst,
- ein Abstandshalter-Element (5), wobei das Abstandhalter-Element (5) zwischen dem optischen Element (4) und der Platine (2) angeordnet ist, wobei das Abstandshalter-Element (5) ein Keramik-Material aufweist,
**dadurch gekennzeichnet,**
**dass** das Abstandshalter-Element (5) derart gestaltet ist, dass der Abstand (δ) zwischen der Platine (2) und dem optischen Element (4) kleiner ist als die Bauhöhe der LED (3).

2. Anordnung nach Anspruch 1,
bei der das Abstandshalter-Element (5) aus dem Keramik-Material besteht.

3. Anordnung nach Anspruch 1,
bei der das Abstandshalter-Element (5) durch ein elektrisches bzw. elektronisches Bauteil gebildet ist, beispielsweise durch einen elektrischen Widerstand oder durch eine Leitungsbrücke.

4. Anordnung nach Anspruch 3,
bei der das elektrische bzw. elektronische Bauteil ein oberflächenmontiertes Bauelement ist bzw. durch Oberflächenmontage an der Platine (2) angeordnet ist.

5. Anordnung nach Anspruch 3 oder 4,
bei der das Abstandshalter-Element (5) durch einen Null-Ohm-Widerstand gebildet ist.

6. Anordnung nach einem der vorhergehenden Ansprüche,
bei der das Abstandshalter-Element (5) unmittelbar auf der Platine (2) angeordnet ist.

7. Anordnung nach Anspruch 6,
bei der durch die Platine (2), die LED (3) und das Abstandshalter-Element (5) ein LED-Modul mit einer integrierten Höhenpositionierung für das optische Element (4) gebildet ist.

8. Anordnung nach einem der vorhergehenden Ansprüche,
bei der das optische Element (4) unmittelbar mit dem Abstandshalter-Element (5) verbunden angeordnet ist, vorzugsweise dabei an dem Abstandshalter-Element (5) mechanisch gehaltert angeordnet ist.

9. Anordnung nach einem der vorhergehenden Ansprüche,
bei der das optische Element (4) ein Linsenelement ist.

10. Anordnung nach Anspruch 9,
bei der das optische Element (4) durch eine Linse, ein Linsenarray, eine Linsenplatte oder eine Kunststoffoptik-Platte gebildet ist.

11. Anordnung nach einem der vorhergehenden Ansprüche,
bei der das optische Element (4) in Spritzgusstechnik oder durch Extrusion gefertigt ist.

12. Anordnung nach einem der vorhergehenden Ansprüche,
weiterhin aufweisend
- wenigstens eine weitere LED zur Erzeugung eines weiteren Lichts, wobei das optische Element (4) derart gestaltet und angeordnet ist, dass es auch das von der wenigstens einen weiteren LED erzeugte weitere Licht optisch beeinflusst.

13. Anordnung nach einem der vorhergehenden Ansprüche,
bei der das Abstandshalter-Element (5) als Positionierhilfe-Element zur Positionierung des optischen Elements (4) relativ zu der LED (3) bzw. relativ zu der Platine (2) ausgestaltet ist.

14. Anordnung nach Anspruch 13,
bei der das Abstandshalter-Element (5) als Positionierhilfe-Element zur Sicherung einer Längsposition des optischen Elements (4) und/oder zur Sicherung einer bestimmten Drehposition des optischen Elements (4) relativ zu der LED (3) bzw. zu der Platine (2) ausgebildet ist.

## Claims

1. An arrangement for emitting light, having
- a circuit board (2),
- an LEC (3) for generating a light,
wherein the LED (3) is arranged on the circuit board (2),
- an optical element (4) which is arranged in such a manner that the optical element optically influences the light generated by the LED (3),
- a spacer element (5) wherein the spacer element (5) is arranged between the optical element (4) and the circuit board (2),
wherein the spacer element (5) has a ceramic material,
**characterized in**
**that** the spacer element (5) is designed in such a manner that the spacing (δ) between the circuit board (2) and the optical element (4) is smaller than the overall height of the LED (3).

2. An arrangement according to Claim 1,
in which the spacer element (5) consists of a ceramic material.

3. An arrangement according to Claim 1,
in which the spacer element (5) is formed by an electrical or electronic component, for example, by an electrical resistor or by a cable link.

4. An arrangement according to Claim 3,
in which the electrical or electronic component is a surface-mounted component or is arranged by surface mounting on the circuit board (2).

5. An arrangement according to claim 3 or 4,
in which the spacer-element (5) is formed by a zero ohm resistor.

6. An arrangement according to any one of the preceding claims,
in which the spacer element (5) is arranged directly on the circuit board (2).

7. An arrangement according to Claim 6,
in which through the circuit board (2), the LED (3) and the spacer-element ((5) an LED module is formed with an integrated positioning in height for the optical element (4).

8. An arrangement according to any one of the preceding claims,
in which the optical element (4) is arranged connected directly to the spacer-element (5), preferably is arranged thereby mechanically held on the spacer-element (5).

9. An arrangement according to any one of the preceding claims,
in which the optical element (4) is a lens element.

10. An arrangement according to Claim 9,
in which the optical element (4) is formed by a lens, a lens array, a lens plate, or a plastic optic plate.

11. An arrangement according to any one of the preceding claims,
in which the optical element (4) is produced in injection molding or by extrusion.

12. An arrangement according to any one of the preceding claims, furthermore having,
- at least one further LED for generating a further light,
wherein the optical element (4) is designed and arranged in such a manner that it also optically influences the further light generated by the at least one further LED.

13. An arrangement according to any one of the preceding claims,
in which the spacer-element (5) is designed as a positioning-aid element for positioning the optical element (4) relative to the LED (3) or relative to the circuit board (2).

14. An arrangement according to Claim 13,
in which the spacer-element (5) is designed as a positioning-aid element for securing a longitudinal position of the optical element (4) and/or for securing a specific rotational position of the optical element (4) relative to the LED (3) or to the circuit board (2).

## Revendications

1. Ensemble destiné à l'émission de lumière, présentant
- une platine (2),
- une LED (3) destinée à la production d'une lumière,
la LED (3) étant disposée sur la platine (2),
- un élément optique (4) qui est disposé de telle sorte qu'il influence optiquement la lumière produite par la LED (3),
- un élément d'espacement (5), l'élément d'espacement (5) étant disposé entre l'élément optique (4) et la platine (2), l'élément d'espacement (5) présentant un matériau en céramique,
**caractérisé en ce que**
l'élément d'espacement (5) est constitué de telle sorte que l'espace (δ) entre la platine (2) et l'élément optique (4) est plus petit que la hauteur de la LED (3).

2. Ensemble selon la revendication 1,
dans lequel l'élément d'espacement (5) se compose du matériau en céramique.

3. Ensemble selon la revendication 1,
dans lequel l'élément d'espacement (5) est formé par un composant électrique ou respectivement électronique, par exemple par une résistance électrique ou par un cavalier.

4. Ensemble selon la revendication 3,
dans lequel le composant électrique ou respectivement électronique est un élément monté en surface ou respectivement est disposé par montage en surface sur la platine (2).

5. Ensemble selon la revendication 3 ou 4,
dans lequel l'élément d'espacement (5) est formé par une résistance zéro ohm.

6. Ensemble selon l'une des revendications précédentes,
dans lequel l'élément d'espacement (5) est disposé directement sur la platine (2).

7. Ensemble selon la revendication 6,
dans lequel un module de LED avec un positionnement en hauteur intégré pour l'élément optique (4) est formé par la platine (2), la LED (3) et l'élément d'espacement (5).

8. Ensemble selon l'une des revendications précédentes,
dans lequel l'élément optique (4) est disposé en étant raccordé directement à l'élément d'espacement (5), est de préférence disposé en l'occurrence en étant supporté mécaniquement sur l'élément d'espacement (5).

9. Ensemble selon l'une des revendications précédentes,
dans lequel l'élément optique (4) est un élément de lentille.

10. Ensemble selon la revendication 9,
dans lequel l'élément optique (4) est formé par une lentille, un groupe de lentilles, une plaque de lentilles ou une plaque en matière plastique optique.

11. Ensemble selon l'une des revendications précédentes,
dans lequel l'élément optique (4) est produit selon la technique de moulage par injection ou par extrusion.

12. Ensemble selon l'une des revendications précédentes, présentant également
- au moins une autre LED destinée à la production d'une autre lumière, l'élément optique (4) étant constitué et disposé de telle sorte qu'il influence également optiquement l'autre lumière produite par l'autre LED au moins au nombre de un.

13. Ensemble selon l'une des revendications précédentes,
dans lequel l'élément d'espacement (5) est constitué en tant qu'élément d'aide au positionnement en vue du positionnement de l'élément optique (4) par rapport à la LED (3) ou respectivement par rapport à la platine (2).

14. Ensemble selon la revendication 13,
dans lequel l'élément d'espacement (5) est constitué en tant qu'élément d'aide au positionnement en vue de bloquer une position longitudinale de l'élément optique (4) et/ou en vue de bloquer une position de rotation définie de l'élément optique (4) par rapport à la LED (3) ou respectivement à la platine (2).
